(19) Europäisches Patentamt

European Patent Office

Office européen des brevets

(11) **EP 3 648 345 B1**

(12) **EUROPEAN PATENT SPECIFICATION**

(45) Date of publication and mention
of the grant of the patent:
**25.03.2026 Bulletin 2026/13**

(21) Application number: **18835340.3**

(22) Date of filing: **20.07.2018**

(51) International Patent Classification (IPC):
*H03F 3/20* ^(2006.01)        *H03F 1/02* ^(2006.01)

(52) Cooperative Patent Classification (CPC):
**H03F 1/0288; H03F 1/0294; H03F 1/32; H03F 1/56;
H03F 3/189; H03F 3/24;** H03F 2200/111;
H03F 2200/246; H03F 2200/391; H03F 2200/451

(86) International application number:
**PCT/CN2018/096421**

(87) International publication number:
**WO 2019/015667 (24.01.2019 Gazette 2019/04)**

(54) **POWER AMPLIFIER**

LEISTUNGSVERSTÄRKER

AMPLIFICATEUR DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.07.2017 CN 201710602258**

(43) Date of publication of application:
**06.05.2020 Bulletin 2020/19**

(73) Proprietor: **Huawei Technologies Co., Ltd.
Longgang District
Shenzhen, Guangdong 518129 (CN)**

(72) Inventors:
• **DU, Qingzhao
Shenzhen
Guangdong 518129 (CN)**
• **SUO, Hailei
Shenzhen
Guangdong 518129 (CN)**
• **LI, Song
Shenzhen
Guangdong 518129 (CN)**

(74) Representative: **Grünecker Patent- und
Rechtsanwälte
PartG mbB
Leopoldstraße 4
80802 München (DE)**

(56) References cited:
WO-A2-2013/071152        CN-A- 102 332 886
CN-A- 103 181 086        CN-A- 104 753 476
CN-A- 105 262 446        CN-A- 105 811 888
CN-A- 106 026 949        CN-A- 106 656 076
CN-B- 103 490 733        CN-Y- 2 163 480
JP-A- H05 175 757        US-A1- 2002 067 212
US-A1- 2015 357 989        US-B2- 7 345 534

• MOHADESKASAEI S ALIREZA ET AL: "A 30 watt
high efficient high power RF pulse power
amplifier", 2016 IEEE MTT-S INTERNATIONAL
CONFERENCE ON NUMERICAL
ELECTROMAGNETIC AND MULTIPHYSICS
MODELING AND OPTIMIZATION (NEMO), IEEE,
27 July 2016 (2016-07-27), pages 1 - 3,
XP032956741, [retrieved on 20160906], DOI:
10.1109/NEMO.2016.7561638
• GAO S ET AL: "TWO-STAGE QUASI-CLASS-E
POWER AMPLIFIER IN GAN HEMT
TECHNOLOGY", IEEE MICROWAVE AND
WIRELESS COMPONENTS LETTERS, IEEE
SERVICE CENTER, NEW YORK, NY, US, vol. 16,
no. 1, 1 January 2006 (2006-01-01), pages 28 - 30,
XP001239516, ISSN: 1531-1309, DOI: 10.1109/
LMWC.2005.861353

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- **ZHUGE TIANXIANG ET AL: "Design of a V-band H-FWG cascaded TWTA", 2015 IEEE INTERNATIONAL VACUUM ELECTRONICS CONFERENCE (IVEC), IEEE, 27 April 2015 (2015-04-27), pages 1 - 2, XP033211699, ISBN: 978-1-4799-7109-1, [retrieved on 20150825], DOI: 10.1109/IVEC.2015.7223946**

## Description

This application claims priority to Chinese Patent Application No. 201710602258.2, filed with the Chinese Patent Office on July 21, 2017 and entitled "POWER AMPLIFIER".

## TECHNICAL FIELD

This application relates to the communications field, and more specifically, to a power amplifier in the communications field.

## BACKGROUND

Development of network systems poses higher requirements for communication capacities. A telecommunications operator increases system capacity by deploying a multi-band wireless system. A multi-band feature of the wireless system requires that a wireless communications device have a multi-band or broadband radio frequency capability. A radio frequency power amplification module is a transmitter module that consumes most energy in wireless communication. Therefore, improving power amplification efficiency is a key to energy saving. An existing power amplifier can have relatively high power amplification efficiency in a single-frequency narrowband signal operating mode, but have relatively low power amplification efficiency in a dual-frequency or multi-frequency concurrent operating mode. Consequently, system performance is relatively poor.

Document US2002/067212A1 (TAKENAKA ISAO [JP]) 6 June 2002 (2002-06-06) discloses an example of a power amplifier configured to amplifier a signal containing multiple carrier frequencies and comprising suppression circuits to remove unwanted signal components at the input and output of the amplifying element.

## SUMMARY

This application provides a power amplifier, to improve power amplification efficiency and system performance.

According to the invention, a power amplifier in accordance with the independent claim is provided. The power amplifier includes: an input end, configured to input at least two signals with different frequencies; a power tube, configured to: amplify the at least two signals input by the input end, and generate a first non-linear increment signal of the at least two signals; a first suppression circuit, configured to suppress the first non-linear increment signal; and an output end, configured to output the at least two signals amplified by the power tube, where the input end is connected to the output end through the power tube, and the power tube is connected to the first suppression circuit.

In this embodiment of this application, after the first suppression circuit suppresses the first non-linear increment signal, an envelope impedance corresponding to the first non-linear increment signal is reduced. In this way, power amplification efficiency of the power amplifier can be improved.

According to the invention, the power tube may be connected to the output end by using the first suppression circuit, so that an envelope impedance of the output end is very low. Therefore, generation of the first non-linear increment signal of an envelope is suppressed, thereby improving power amplification efficiency in a dual-frequency or multi-frequency concurrency scenario.

When the first suppression circuit suppresses the first non-linear increment signal, an output impedance of the power tube does not include an output impedance of the first non-linear increment signal. Therefore, power consumption of the power amplifier is reduced.

Optionally, the at least two signals with different frequencies may be at least two dual-frequency or multi-frequency concurrent signals.

Optionally, the output end may output the at least two amplified signals to a duplexer, an antenna and feeder, or the like.

Optionally, the output end may alternatively output the at least two amplified signals to a next-stage power amplifier. In this embodiment of this application, in a dual-frequency or multi-frequency operating mode, the first suppression circuit does suppress a non-linear increment signal generated in a process in which the power tube amplifies a dual-frequency or multi-frequency signal. In this way, the output end is prevented from outputting the non-linear increment signal generated during amplification of the dual-frequency or multi-frequency signal to the next-stage power amplifier, and the next-stage power amplifier is prevented from amplifying the non-linear increment signal, to reduce power consumption of the amplifier. Therefore, power amplification efficiency of the next-stage power amplifier can be improved.

In accordance with the invention, the first suppression circuit includes a first capacitor and a first inductor, and the first inductor and the first capacitor are configured to perform short-circuit processing on an impedance at a frequency of the first non-linear increment signal.

A series resonance is presented at the frequency of the first non-linear increment signal, which approximates to being short-circuited to the ground.

Optionally, the first suppression circuit may alternatively be capacitor and inductor elements of lumped elements, or may be other equivalent elements (for example, a microstrip and a varactor) that have similar functions as the capacitor and the inductor.

Optionally, the first inductor and the first capacitor are connected in series.

In some implementations, a resonance frequency of the first inductor and the first capacitor is determined by the frequencies of the at least two signals.

In accordance with the invention, the resonance frequency of the first inductor and the first capacitor is determined by a difference between the frequencies of the at least two signals.

In an example not in accordance with the invention, if the frequencies of the at least two signals input by the input end are constant, a capacitance value of the first capacitor and an inductance value of the first inductor are constant, and the capacitance value of the first capacitor and the inductance value of the first inductor are determined based on the frequencies of the at least two signals, so that a resonance frequency of the first suppression circuit including the first capacitor and the first inductor is constant. In accordance with the invention, the frequencies of the at least two signals input by the input end are variable, for example, at least one of frequencies of at least two signals input at the first time is different from frequencies of at least two signals input at the second time, an inductance value of the first inductor and a capacitance value of the first capacitor are adjustable, and vary with different frequencies of input signals, so that a resonance frequency of the first suppression circuit is adjustable.

Optionally, if the first non-linear increment signal is one component, the first suppression circuit may include one group of first capacitors and first inductors. If the first non-linear increment signal is M components, a first suppression circuit includes M groups of first capacitors and first inductors. Optionally, capacitance values of first capacitors in each group of the M groups of first capacitors may be different, and inductance values of first inductors in each group of the M groups of first inductors may be different, where M is an integer greater than or equal to 1.

Optionally, if two signals with different frequencies are input, the first suppression circuit includes one group of first inductors and first capacitors. If three signals with different frequencies are input, the first suppression circuit includes three groups of first capacitors and first inductors. If N signals with different frequencies are input, the first suppression circuit includes $C_N^2$ groups of first capacitors and first inductors, where N is an integer greater than or equal to 2.

Optionally, if the input signals are signals that are input in a dual-frequency concurrency scenario and whose carrier frequencies are F1 and F2, a spectrum generated by the power amplifier mainly includes the following spectral components: fundamental frequency components F1 and F2, an envelope component F2-F1, third order intermodulation components 2*F2-F1 and 2*F1-F2, second harmonic components 2*F1, 2*F2, and F1+F2, third harmonic components 3*F1, 3*F2, 2*F1+F2, 2*F2+F1, and the like. Optionally, the first suppression circuit in this embodiment of this application may suppress an envelope component. Optionally, the first suppression circuit in this embodiment of this application may suppress at least one of an envelope component, a third order intermodulation component, or a second harmonic component. When the first suppression circuit suppresses at least two components, the first suppression circuit may include at least two groups of first capacitors and first inductors.

Optionally, a quantity of groups of first inductors and first capacitors included in the first suppression circuit may be determined based on requirements. For example, the quantity of groups of first capacitors and first inductors included in the first suppression circuit may be equal to a quantity of components that the first suppression circuit needs to suppress. The quantity of groups of first capacitors and first inductors is not limited by a frequency of an input signal.

In accordance with the invention, the input end is further configured to input, to the power tube, a second non-linear increment signal generated by a previous-stage power amplifier; and the power amplifier further includes: a second suppression circuit, configured to suppress the second non-linear increment signal, where the input end is connected to the second suppression circuit.

Optionally, the input end is connected to the power tube by using the second suppression circuit, so that an envelope impedance input by the input end may be very low. Therefore, generation of a second non-linear increment signal of an envelope can be suppressed, thereby improving power amplification efficiency in a dual-frequency or multi-frequency concurrency scenario.

In accordance with the invention, the second suppression circuit includes a second capacitor and a second inductor, and the second capacitor and the second inductor are configured to perform short-circuit processing on an impedance at a frequency of the second non-linear increment signal.

Optionally, a series resonance is presented at the frequency of the second non-linear increment signal, which approximates to being short-circuited to the ground.

Optionally, the second suppression circuit may alternatively be capacitor and inductor elements of lumped elements, or may be other equivalent elements (for example, a microstrip and a varactor) that have similar functions as the capacitor and the inductor.

Optionally, the second capacitor and the second inductor are connected in series.

Optionally, if the second non-linear increment signal is one component, the second suppression circuit may include one group of second capacitors and second inductors. If the second non-linear increment signal is P components, the second suppression circuit includes P groups of second capacitors and second inductors. Optionally, capacitance values of second capacitors in each group of the P groups of second capacitors and second inductors may be different, and inductance values of second inductors in each group of the P groups of second inductors may be different, where P is an integer greater than or equal to 1.

In accordance with the invention, a resonance frequency of the second inductor and the second capacitor is determined by frequencies of input signals of the previous-stage power amplifier.

In accordance with the invention, the resonance frequency of the second inductor and the second capacitor is determined by a difference between the frequencies of the input signals of the previous-stage power amplifier.

Optionally, the input signals of the previous-stage power amplifier may alternatively be at least two signals with different frequencies.

In some implementations, the power amplifier further includes: an input matching circuit, configured to match a first impedance of the input end into a second impedance input by the power tub; an output matching circuit, configured to match a third impedance output by the power tube into a fourth impedance of the output end, where the input end is connected to the power tube by using the input matching circuit, and the power tube is connected to the output end by using the output matching circuit.

In some implementations, the power amplifier further includes: an input bias circuit, configured to supply power to the power tube by using the input matching circuit; and an output bias circuit, configured to supply power to the power tube by using the output matching circuit.

Optionally, the input bias circuit may be directly connected to the power tube, and the output bias circuit may be directly connected to the power tube.

According to a third aspect. not in accordance with the claimed invention, the power amplifier according to the first aspect or any implementation of the first aspect may be a Doherty power amplifier or an outphasing amplifier.

## BRIEF DESCRIPTION OF DRAWINGS

FIG. 1 is a schematic diagram of an application scenario according to an embodiment of this application;
FIG. 2 shows a power amplifier according to an embodiment of this application;
FIG. 3 shows another power amplifier according to an embodiment of this application;
FIG. 4 is a schematic diagram of an effect of a power amplifier in the prior art;
FIG. 5 is a schematic diagram of efficiency of a power amplifier according to an embodiment of this application;
FIG. 6 shows still another power amplifier according to an embodiment of this application;
FIG. 7 shows still another power amplifier according to an embodiment of this application;
FIG. 8 shows still another power amplifier according to an embodiment of this application;
FIG. 9 shows still another power amplifier according to an embodiment of this application;
FIG. 10 shows still another power amplifier according to an embodiment of this application;
FIG. 11 shows still another power amplifier according to an embodiment of this application; and
FIG. 12 shows still another power amplifier according to an embodiment of this application.

## DESCRIPTION OF EMBODIMENTS

A power amplifier provided in this application may be applied to a radio frequency module of a transmit end in various communications systems, for example, a global system for mobile communications (global system of mobile communication, GSM), a code division multiple access (code division multiple access, CDMA) system, a wideband code division multiple access (wideband code division multiple access, WCDMA) system, a general packet radio service (general packet radio service, GPRS) system, a long term evolution (long term evolution, LTE) system, an LTE frequency division duplex (frequency division duplex, FDD) system, an LTE time division duplex (time division duplex, TDD) system, a universal mobile telecommunications system (universal mobile telecommunication system, UMTS), a worldwide interoperability for microwave access (worldwide interoperability for microwave access, WiMAX) communications system, a wireless local area network (wireless local area network, WLAN) system, or a future fifth generation wireless communications system (the fifth Generation, 5G).

In a single frequency narrowband signal operating mode, a signal amplified by an existing power amplifier is a narrowband signal, for example, a modulation signal at 1840 MHz or a modulation signal at 2140 MHz, and efficiency of the power amplifier is relatively high. In a dual-frequency or multi-frequency concurrent operating mode, a signal amplified by the existing power amplifier is a broadband signal, for example, a modulation signal at 1840 MHz+2140 MHz. In the dual-frequency or multi-frequency operating mode, due to a non-linear feature of a power tube, a wide range of spectral components are output by the power amplifier. For example, in a dual-frequency concurrency scenario in which there are carrier frequencies F1 and F2, a spectrum generated by the power amplifier mainly includes the following spectral components: fundamental frequency components F1 and F2, an envelope component F2-F1, third order intermodulation components 2*F2-F1 and 2*F1-F2, second harmonic components 2*F1, 2*F2, and F1+F2, third harmonic components 3*F1, 3*F2, 2*F1+F2, 2*F2+F1, and the like, where the fundamental frequency components are wanted signals, and other components generated by the power amplifier are non-linear increment signals. These non-linear increment signals are unwanted signals. These components interfere with signals of another device, and the amplifier also amplifies the non-linear increment signals in an amplification process. Therefore, the amplified non-linear increment signals interfere with the signals of the another device more severely. In addition, the non-linear increments deteriorate efficiency of the power amplifier. Consequently, the efficiency of the amplifier in the dual-frequency or multi-frequency operating mode decreases. Experiments have proved that the envelope component is critical to efficiency of a broadband amplifier. For example, Table 1 compares efficiency of a power amplifier in single-frequency and dual-frequency operating modes. Power amplification efficiency represents a ratio of an output power to power consumption. It should be understood that in this embodiment of this application, the power amplification efficiency may alternatively be a ratio of a difference between an output power and an input power to power consumption. The power amplification efficiency in Table 1 is the former definition.

**Table 1**

| Frequency band | Test case | Output power (dBm) | Power amplification efficiency |
|---|---|---|---|
| 1840 MHz | LTE1C20M | 50.5 | 52.96% |
| 2140 MHz | LTE1C20M | 50.97 | 53.13% |
| 1840 MHz+2140 MHz | Two concurrent LTE_20M signals | 50.86 | 47.74% |

To resolve the foregoing problem, the power amplifier provided in the embodiments of this application can suppress the non-linear increment signal in an amplification process, so that the power amplifier can be prevented from also amplifying power of the non-linear increment signal in the amplification process, and the power amplification efficiency of the power amplifier can be improved.

It should be understood that the power amplifier in the embodiments of this application may be applied to a power amplifier architecture such as a Doherty power amplifier architecture, an outphasing (Outphasing) amplifier, or an envelope tracking amplifier, or may be applied to another highly efficient power amplifier architecture. This is not limited in the embodiments of this application.

It should be understood that, that A is connected to B in the embodiments of this application means that A and B may be connected in series or may be connected in parallel, or A is connected to B by using another component. This is not limited in the embodiments of this application.

It should be understood that the first non-linear increment, the second non-linear increment, or the non-linear increment in the embodiments of this application may be an envelope component, or may be all or some envelope components generated by the amplifier in a process of amplifying a signal. This is not limited in the embodiments of this application.

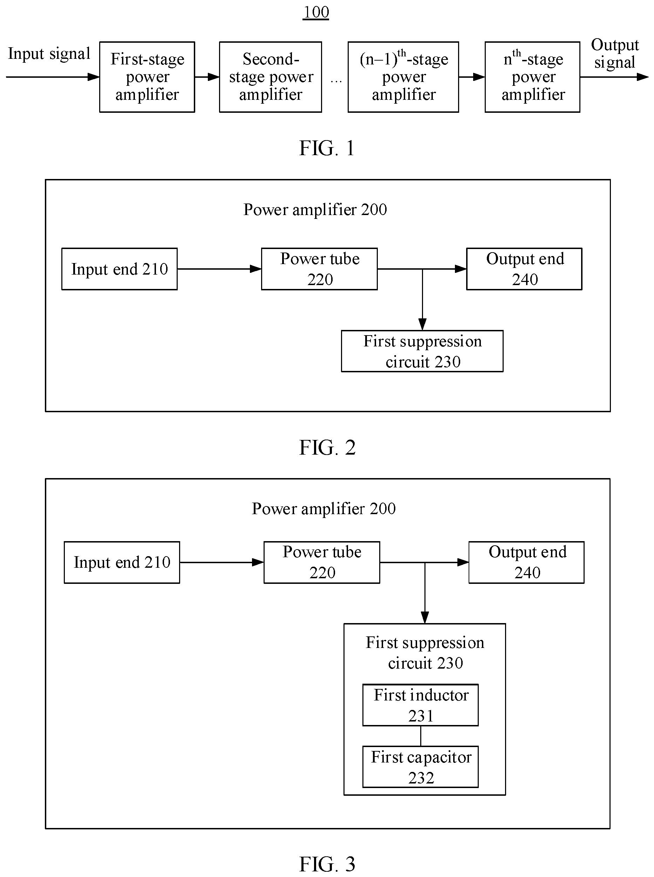

The embodiments of this application may be applied to a multi-stage amplifier scenario. Certainly, the embodiments of this application are not limited to a multi-stage amplifier, and may alternatively be applied to a one-stage amplifier. For example, as shown in FIG. 1, the amplification circuit includes n stages of amplifiers, where n is an integer greater than or equal to 1. All amplifiers in FIG. 1 can work in a dual-frequency or multi-frequency operating mode. For example, the amplifier in the embodiments of this application may be a first-stage amplifier. A first suppression circuit in the amplifier is connected to an output end of the amplifier. The first suppression circuit is configured to suppress a non-linear increment signal generated in the amplifier. When the output end is connected to the first suppression circuit, an envelope impedance input by an input end may be very low. Therefore, generation of a first non-linear increment signal of an envelope can be suppressed, thereby improving power amplification efficiency in a dual-frequency or multi-frequency concurrency scenario. Alternatively, when a signal output by the first-stage amplifier is input to a second-stage amplifier, the second-stage amplifier can avoid amplifying the non-linear increment signal generated by the first-stage amplifier, thereby reducing power consumption of the second-stage amplifier. For another example, the amplifier in the embodiments of this application may be a second-stage amplifier. A second suppression circuit in the amplifier is connected to the input end of the amplifier, and the second suppression circuit is configured to suppress a non-linear increment signal generated by the first-stage amplifier. In this way, before the amplifier amplifies a signal, generation of a second non-linear increment signal may be suppressed, so that an envelope impedance input by the input end is very low, thereby improving power amplification efficiency in a dual-frequency or multi-frequency concurrency scenario. Alternatively, the second-stage amplifier includes a first suppression circuit and a second suppression circuit. The first suppression circuit is connected to the output end, so that an envelope impedance of the output end is very low. Therefore, generation of a first non-linear increment signal of an envelope can be suppressed, thereby improving power amplification efficiency of the second-stage amplifier and/or power amplification efficiency of a third-stage amplifier. The second suppression circuit is connected to the input end, so that a non-linear increment signal of an envelope generated by the first-stage amplifier can be suppressed. Therefore, an envelope impedance input by the input end is very low, thereby improving power amplification efficiency of the second-stage amplifier. For still another example, the amplifier in the embodiments of this application may be an $n^{th}$-stage amplifier, the second suppression circuit in the amplifier is connected to the input end of the amplifier, and the second suppression circuit is configured to suppress a non-linear increment signal generated by an $(n-1)^{th}$-stage amplifier. In this way, before the amplifier amplifies a signal, the non-linear increment signal generated by the $(n-1)^{th}$-stage amplifier can be suppressed, so that an envelope impedance of the input end is very low. Therefore, the amplifier is prevented from amplifying the non-linear increment signal generated by the $(n-1)^{th}$-stage amplifier, thereby improving power amplification efficiency of the amplifier. For another example, the amplifier in the embodiments of this application may be an $n^{th}$-stage amplifier, the first suppression circuit in the amplifier is connected to the output end of the amplifier, and the first suppression circuit of the amplifier is configured to suppress a non-linear increment signal generated by the amplifier. An envelope impedance output by an output end of a power tube in the $n^{th}$-stage amplifier is very low, thereby improving power amplification efficiency of the $n^{th}$-stage amplifier. For another example, the amplifier in the embodiments of this application may be an $n^{th}$-stage amplifier, a first suppression circuit in the amplifier is connected to an output end of the amplifier, a second suppression circuit in the amplifier is connected to the input end of the amplifier, and the first suppression circuit is configured to suppress a non-linear increment signal generated by an $(n-1)^{th}$-stage amplifier. Therefore, the $n^{th}$-stage amplifier can be prevented from amplifying the non-linear increment signal generated by the $(n-1)^{th}$-stage amplifier, and an envelope impedance of an input end of the $n^{th}$-stage amplifier may be very low. The second suppression circuit is configured to suppress the non-linear increment signal generated by the $n^{th}$-stage amplifier, so that an envelope impedance of an output end of the $n^{th}$-stage amplifier is very low. This can significantly suppress generation of an envelope component, thereby improving power amplification efficiency in the dual-frequency or multi-frequency concurrency scenario.

It should be understood that, in FIG. 1, the $(n-1)^{th}$-stage amplifier may be referred to as a previous-stage power amplifier of the $n^{th}$-stage amplifier, and the $n^{th}$-stage amplifier may be referred to as a next-stage power amplifier of the $(n-1)^{th}$-stage amplifier. For example, the first-stage amplifier may be referred to as a previous-stage power amplifier of the second-stage amplifier, and the second-stage amplifier may be referred to as a next-stage power amplifier of the first-stage amplifier.

The following describes the power amplifier provided in the embodiments of this application with reference to the accompanying drawings.

FIG. 2 shows a power amplifier 200 provided in an embodiment of this application. For example, the power amplifier 200 may be any one of the n power amplifiers in FIG. 1, for example, may be the $n^{th}$-stage amplifier in FIG. 1. The power amplifier 200 includes: an input end 210, a power tube 220, a first suppression circuit 230, and an output end 240.

The input end 210 is configured to input at least two signals with different frequencies. The at least two signals may be same signals or may be different signals. This is not limited in this embodiment of this application.

The power tube 220 is configured to: perform power amplification on the at least two signals input by the input end 210, and generate a first non-linear increment signal of the at least two signals. For example, the power tube 220 may amplify the at least two signals with different frequencies input by the input end 210, to obtain at least two amplified signals, and the power tube 220 generates the first non-linear increment signal of the at least two signals when amplifying the at least two signals with different frequencies.

The first suppression circuit 230 is configured to suppress the first non-linear increment signal.

The output end 240 is configured to output the at least two signals amplified by the power tube 220.

The input end 210 is connected to the output end 240 through the power tube 220, and the power tube 220 is connected to the first suppression circuit 230, for example, the connection manner in FIG. 1; or the power tube 220 is connected to the output end 240 by using the first suppression circuit 230, and the first suppression circuit 230 is configured to suppress the first non-linear increment signal output by the power tube 220, provided that the first suppression circuit 230 is connected after the power tube 220 and before the output end 240. A specific connection relationship is not limited in this application.

Therefore, in a dual-frequency or multi-frequency operating mode, the first suppression circuit 230 may suppress a non-linear increment signal generated in a process in which the power tube 220 amplifies a dual-frequency or multi-frequency signal. After the first suppression circuit 230 suppresses the first non-linear increment signal, an envelope impedance of the output end is very low. Therefore, the first non-linear increment signal of an envelope can be significantly suppressed, thereby improving power amplification efficiency of the power amplifier in a dual-frequency or multi-frequency concurrency scenario.

Optionally, the output end 240 is connected to a duplexer, an antenna and feeder, or the like.

Optionally, when the output end 240 is connected to a next-stage power amplifier, the first suppression circuit 230 may suppress a non-linear increment signal generated in a process in which the power tube 220 amplifies a dual-frequency or multi-frequency signal. In this way, the output end may be prevented from outputting the non-linear increment signal generated during amplification of the dual-frequency or multi-frequency signal, and the next-stage network may be prevented from amplifying the non-linear increment signal, to reduce power consumption of the amplifier. Therefore, power amplification efficiency of the next-stage network can be improved.

In an optional embodiment, as shown in FIG. 3, the first suppression circuit 230 includes a first inductor 231 and a first capacitor 232, where the first inductor 231 and the first capacitor 232 are configured to perform short-circuit processing on an impedance at a frequency of the first non-linear increment signal. For example, the first inductor 231 and the first capacitor 232 may be connected in series.

Optionally, the first suppression circuit may alternatively be capacitor and inductor elements of lumped elements, or may be other equivalent elements (for example, a microstrip and a varactor) that have similar functions as the capacitor and the inductor.

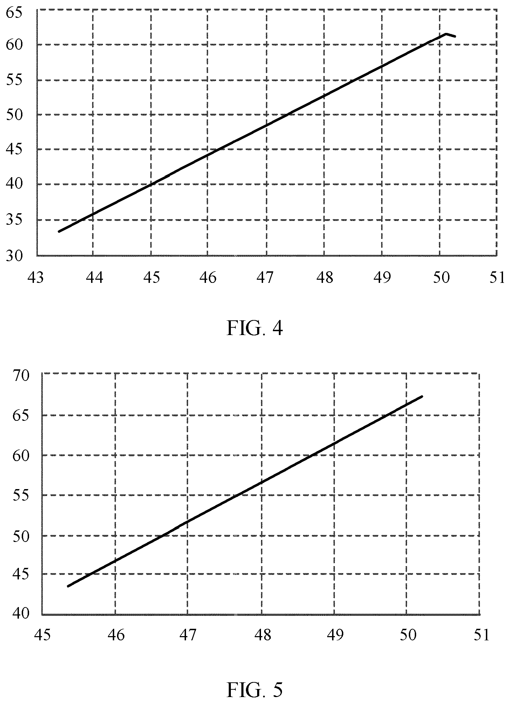

In accordance with the invention, a resonance frequency of the first inductor 231 and the first capacitor 232 is determined by the frequencies of the at least two signals. Specifically, the resonance frequency of the first inductor 231 and the first capacitor 232 is determined by a difference between the frequencies of the at least two signals. When a frequency of a signal input by the input end 210 is constant, the resonance frequency of the first inductor 231 and the first capacitor 232 is constant. For example, when frequencies of two signals input by the input end 210 are 1840 MHz and 2140 MHz, the resonance frequency of the first inductor 231 and the first capacitor 232 is 300 MHz (2140 MHz to 1840 MHz). In this way, in a dual-frequency concurrency scenario, a non-linear signal increment of 300 MHz generated by the power amplifier can be reduced. As shown in FIG. 4 and FIG. 5, horizontal coordinates in FIG. 4 and FIG. 5 indicate output powers, and vertical coordinates indicate power amplification efficiency. FIG. 4 indicates power amplification efficiency of a next-stage amplifier before the first suppression circuit 230 is added. FIG. 5 indicates power amplification efficiency of a next-stage amplifier after the first suppression circuit 230 is added. It can be learned that the power amplification efficiency increases by five percentage points after the first suppression circuit 230 is added. For another example, when three signals with different frequencies are input by the input end 210, assuming that the frequencies of the three signals are A, B, and C in descending order, three groups of capacitor and inductor combination circuits may be added as required. Each group of capacitors and inductors may be the first capacitor 232 and the first inductor 231, and resonance frequencies of the three groups of capacitors and inductors are A-B, A-C, and B-C respectively. When a frequency of a signal input by the input end is variable, the first inductor 231 and the first capacitor 232 may vary with the frequency of the signal input by the input end. In other words, an inductance value of the first inductor 231 and a capacitance value of the first capacitor 232 are adaptive and adjustable, so that a resonance frequency becomes adaptive and adjustable with the frequency of the input signal.

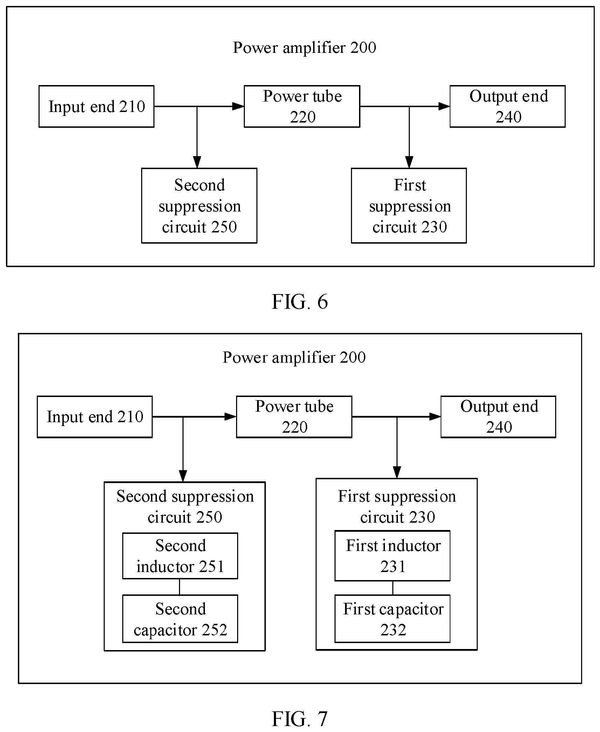

In an embodiment, the input end 210 is further configured to input, to the power tube 220, a second non-linear increment signal generated by a previous-stage power amplifier; and the power amplifier 200 further includes: a second suppression circuit 250, configured to suppress the second non-linear increment signal, where the input end 210 is connected to the second suppression circuit 250, for example, the connection manner in FIG. 6. The input end 210 is connected to the power tube 220 by using the second suppression circuit 230, and the second suppression circuit 230 is configured to suppress the second non-linear increment signal that is of the previous-stage power amplifier and that is input by the input end 210, provided that the second suppression circuit 230 is connected after the output end 240 and before the power tube 220. A specific connection relationship is not limited in this application. The power amplifier may be a power amplifier other than the first-stage power amplifier in FIG. 1.

In an embodiment, as shown in FIG. 7, the second suppression circuit 250 includes a second inductor 251 and a second capacitor 252, where the second inductor 251 and the second capacitor 252 are configured to perform short-circuit processing on an impedance at a frequency of the second non-linear increment signal. For example, a connection relationship between the second inductor 251 and the second capacitor 252 may be similar to the connection relationship between the first inductor 231 and the first capacitor 232 in FIG. 4.

In an embodiment, a resonance frequency of the second inductor 251 and the second capacitor 252 is determined by frequencies of input signals of the previous-stage power amplifier. The resonance frequency of the second inductor 251 and the second capacitor 252 is determined by a difference between the frequencies of the input signals of the previous-stage power amplifier. Specifically, if a signal input by the previous-stage power amplifier is a dual-frequency or multi-frequency concurrent signal, the resonance frequency of the second inductor 251 and the second capacitor 252 of the amplifier 200 is determined by a frequency of the dual-frequency or multi-frequency concurrent signal of the previous-stage power amplifier. If the frequency of the signal input by the previous-stage power amplifier is constant, the resonance frequency of the second inductor 251 and the second capacitor is constant. For example, when frequencies of two signals input by the previous-stage power amplifier are 1840 MHz and 2140 MHz, the resonance frequency of the second inductor 251 and the second capacitor 252 is 300 MHz (2140 MHz to 1840 MHz). When the frequency of the dual-frequency or multi-frequency concurrent signal input by the previous-stage power amplifier is variable, the resonance frequency of the second inductor 251 and the second capacitor 252 may vary with the frequency of the concurrent signal of the previous-stage power amplifier, in other words, the resonance frequency of the second inductor 251 and the second capacitor 252 is adaptive and adjustable.

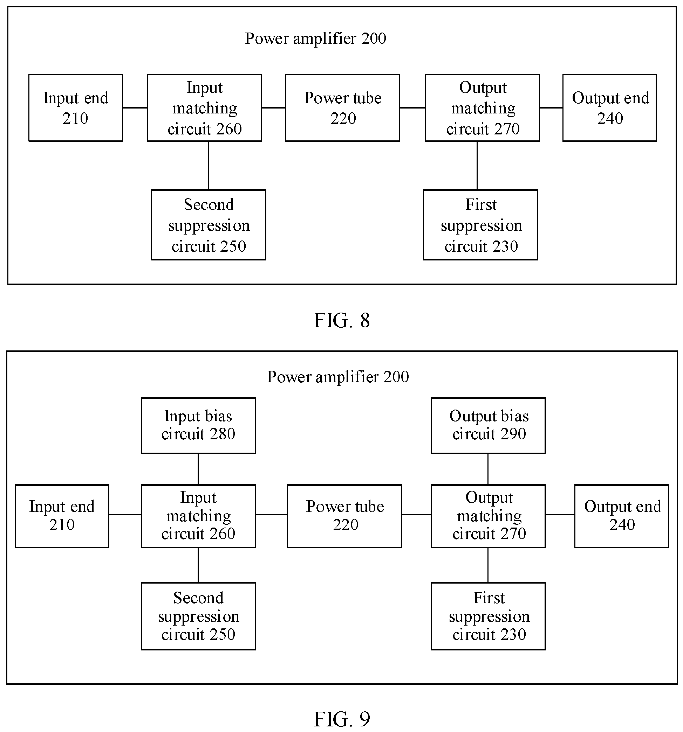

In an optional embodiment not in accordance with the claim, as shown in FIG. 8, the power amplifier 200 further includes: an input matching circuit 260, configured to match a first impedance of the input end 210 into a second impedance input by the power tub 220; an output matching circuit 270, configured to match a third impedance output by the power tube 220 into a fourth impedance of the output end 240, where the input end 210 is connected to the power tube by using the input matching circuit 260, and the power tube 220 is connected to the output end 240 by using the output matching circuit 270. For example, the second inductor 251 and the second capacitor 252 that are included in the second suppression circuit 250 may be connected in series on the input matching circuit 260, and the first inductor 231 and the first capacitor 232 that are included in the first suppression circuit 230 may be connected in series on the output matching circuit 270. Optionally, the second suppression circuit 250 shown in FIG. 8 may be connected to the input matching circuit 260. Certainly, the input end 210 may alternatively be connected to the input matching circuit 260 by using the second suppression circuit 250. The input matching circuit 260 is connected to the output matching circuit 270 through the power tube 220. Optionally, the first suppression circuit 230 may be connected to the output matching circuit 270. Certainly, the power tube 220 may alternatively be connected to the first suppression circuit 230 by using the output matching circuit 270. The output matching circuit 270 is connected to the output end 240 by using the first suppression circuit 230.

In an optional embodiment not in accordance with the claim, as shown in FIG. 9, the power amplifier 200 further includes: an input bias circuit 280, configured to supply power to the power tube by using the input matching circuit 260; and an output bias circuit 290, configured to supply power to the power tube by using the output matching circuit 270.

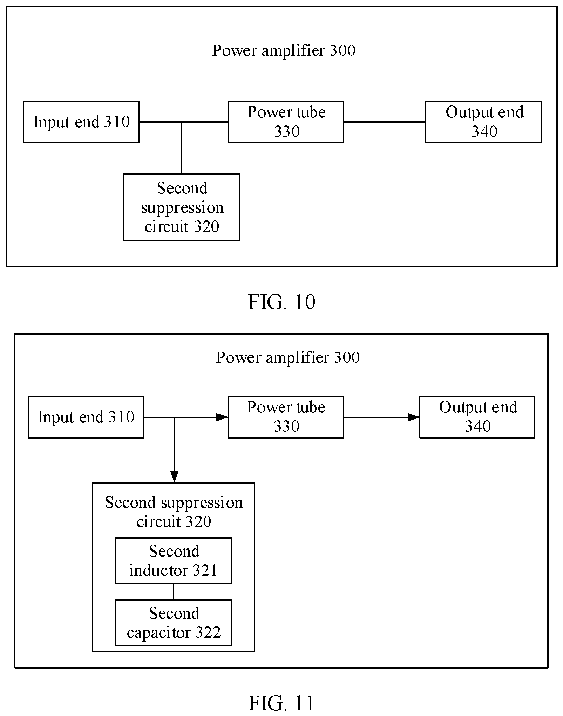

It should be understood that the connection relationships between the components of the amplifier in the foregoing figures in the embodiments of this application are examples, and do not constitute any limitation on the embodiments of this application. FIG. 10 shows another power amplifier 300 according to an embodiment of this application. The power amplifier 300 includes:

an input end 310, configured to input at least two signals with different frequencies and a second non-linear increment signal generated by a previous-stage power amplifier;
a second suppression circuit 320, configured to suppress the second non-linear increment signal input by the input end 310;
a power tube 330, configured to perform power amplification on the at least two signals with different frequencies input by the input end 310, to obtain at least two amplified signals; and
an output end 340, configured to output the at least two amplified signals. The input end 310 is connected to the power tube 330, and the input end 310 is connected to the output end 340 through the power tube 330, for example, the connection manner in FIG. 9. Alternatively, the input end 310 is connected to the power tube 330 by using the second suppression circuit 320, and the second suppression circuit 320 is configured to suppress the second non-linear increment signal that is generated by the previous-stage power amplifier and that is input by the input end 310, provided that the second suppression circuit 320 is connected after the input end 310 and before the power tube 330. A specific connection relationship is not limited in this application.

Therefore, in a dual-frequency or multi-frequency operating mode, the second suppression circuit 320 may suppress a non-linear increment signal generated in a process of amplifying a dual-frequency or multi-frequency signal by the previous-stage power amplifier. In this way, the power amplifier 300 may be prevented from amplifying the non-linear increment signal generated by the previous-stage power amplifier, so that an envelope impedance input by the input end is very low, thereby reducing power consumption of the power amplifier 300, and improving power amplification efficiency of the power amplifier 300.

In an optional embodiment, as shown in FIG. 11, the second suppression circuit 320 includes a second inductor 321 and a second capacitor 322, where the second inductor 321 and the second capacitor 322 are configured to perform short-circuit processing on an impedance at a frequency of the second non-linear increment signal.

In an optional embodiment, a resonance frequency of the second inductor 321 and the second capacitor 322 is determined by frequencies of input signals of the previous-stage power amplifier.

In an optional embodiment, the resonance frequency of the second inductor 321 and the second capacitor 322 is determined by a difference between the frequencies of the input signals of the previous-stage power amplifier.

It should be understood that the second inductor 321 and the second capacitor 322 that are included in the second suppression circuit 320 in the power amplifier 300 are similar to the second inductor 251 and the second capacitor 252 that are included in the second suppression circuit 250 in the power amplifier 200. To avoid repetition, details are not described herein again.

Optionally, the power amplifier 300 may further include an input matching circuit, an output matching circuit, an input bias circuit, an output bias circuit, and the like. For a specific connection relationship, refer to the connection relationship in the power amplifier 200. To avoid repetition, details are not described in this embodiment of this application again.

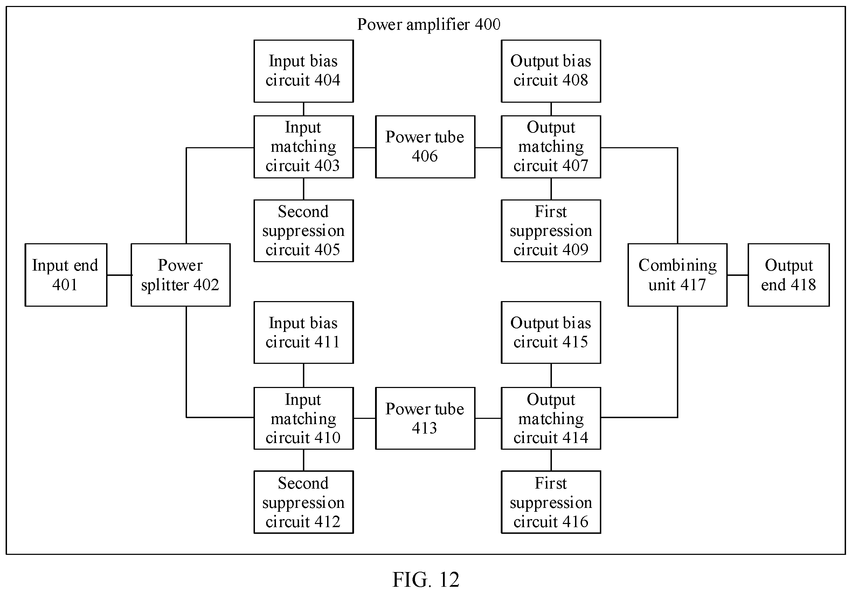

In an example, FIG. 12 shows a power amplifier 400 in a Doherty power amplification architecture according to an embodiment of this application. The power amplifier 400 includes:

an input end 401, configured to: input a non-linear increment signal output by a previous-stage power amplifier and a dual-frequency or multi-frequency concurrent signal that needs to be amplified, or input at least two signals with different frequencies;

a power splitter 402, configured to replicate a signal input by the input end 401, to obtain a first branch signal and a second branch signal, where the first branch signal is a non-linear increment signal input by the input end 401 and is a dual-frequency or multi-frequency concurrent signal that needs to be amplified, and the second branch signal is a non-linear increment signal input by the input end 401 and is a dual-frequency or multi-frequency concurrent signal that needs to be amplified.

an input matching circuit 403, configured to match an impedance of the first branch signal output by the power splitter 402 into an impedance of a power tube 406;

an input bias circuit 404, configured to supply power to the power tube 406;

a second suppression circuit 405, configured to: when the input end 401 inputs the non-linear increment signal output by the previous-stage power amplifier and a signal that needs to be amplified, suppress a non-linear increment signal allocated by the power splitter 420 to a first branch, where the non-linear increment signal is generated by the previous-stage power amplifier;

the power tube 406, configured to amplify signals that are of the first branch and that have different frequencies, where optionally, the power tube 406 is further configured to amplify a non-linear increment signal that is not suppressed by the second suppression circuit 405;

an output matching circuit 407, configured to match an impedance output by the power tube 406 into an impedance of a combining unit 417;

an output bias circuit 408, configured to supply power to the power tube 406;

a first suppression circuit 409, configured to suppress the non-linear increment signal generated by the power tube 406 and a non-linear increment signal obtained by amplifying the non-linear increment signal that is not suppressed by the second suppression circuit 405;

an input matching circuit 410, configured to match a first impedance of the second branch signal output by the power splitter 402 into a second impedance of a power tube 413;

an input bias circuit 411, configured to supply power to the power tube 413;

a second suppression circuit 412, configured to: when the input end 401 inputs the non-linear increment signal output by the previous-stage power amplifier and a signal that needs to be amplified, suppress a non-linear increment signal allocated by the power splitter 420 to a second branch, where the non-linear increment signal is generated by the previous-stage power amplifier.

the power tube 413, configured to amplify signals that are of the first branch and that have different frequencies, where optionally, the power tube 413 is further configured to amplify a non-linear increment signal that is not suppressed by the second suppression circuit 412;

an output matching circuit 414, configured to match an impedance output by the power tube 413 into an impedance of the combining unit 417;

an output bias circuit 415, configured to supply power to the power tube 413;

a first suppression circuit 416, configured to suppress a non-linear increment signal generated by the power tube 413 and a non-linear increment signal obtained by amplifying the non-linear increment signal that is not suppressed by the second suppression circuit 412;

the combining unit 417, configured to combine signals of the first branch and the second branch, where optionally the combining unit 417 may further be configured to convert an impedance, and configured to match impedances of the output matching circuit 407 and the output matching circuit 414 into an impedance of an output end 418; and

the output end 418, configured to output an amplified signal combined by the combining unit 417.

The input end 401 may be the input end 210 or the input end 310. The input matching circuit 403 or the input matching circuit 410 may be the input matching circuit 260. The input bias circuit 404 or the input bias circuit 411 may be the input bias circuit 280. The second suppression circuit 405 or the second suppression circuit 412 may be the second suppression circuit 250 or the second suppression circuit 320. The power tube 406 or the power tube 413 may be the power tube 220 or the power tube 330. The output matching circuit 407 or the output matching circuit 414 may be the output matching circuit 270. The output bias circuit 408 or the output bias circuit 415 may be the output bias circuit 290. The first suppression circuit 409 or the first suppression circuit 416 may be the first suppression circuit 230. The output end 418 may be the output end 240 or the output end 340. The input end 401 is connected to the input matching circuit 403 and the input matching circuit 410 by using the power splitter 402. The power splitter 402 is connected to the power tube 406 by using the input matching circuit 403. The input bias circuit 404 is connected to the power tube 406 by using the input matching circuit 403. The second suppression circuit 405 is connected to the input matching circuit 403. The power tube 406 is connected to the combining unit 417 by using the output matching circuit 407. The output bias circuit 408 is connected to the power tube 406 by using the output matching circuit 408. The first suppression circuit 409 is connected to the output matching circuit 407. The power splitter 402 is connected to the power tube 413 by using the input matching circuit 410. The input bias circuit 411 is connected to the power tube 413 by using the input matching circuit 410. The second suppression circuit 412 is connected to the input matching circuit 410. The power tube 413 is connected to the combining unit 417 by using the output matching circuit 414. The output bias circuit 415 is connected to the power tube 413 by using the output matching circuit 414. The first suppression circuit 416 is connected to the output matching circuit 414.

It should be understood that, in this embodiment of this application, suppressing a non-linear increment signal may be that a series resonance is presented at a frequency of the non-linear increment signal, which approximates to being short-circuited to the ground; or suppressing a non-linear increment signal may be performing short-circuit processing on an impedance of the non-linear increment signal. However, this is not limited in this embodiment of this application, and suppression processing may be performed in another manner.

It should be understood that the power amplifier 200, the power amplifier 300, or the power amplifier 400 may be discrete devices, or may be used as one circuit unit, or may be combined into a highly efficient power amplifier module, for example, a Doherty power amplifier or an outphasing amplifier.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners within the scope defined by the claim.

For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the appended claim.

**Claims**

1.　A power amplifier (200), comprising:

　an input end (210), configured to input at least two signals with different frequencies;
　a power tube (220), configured to:

　　amplify the at least two signals input by the input end (210), and
　　generate a first non-linear increment signal of the at least two signals;

　a first suppression circuit (230), configured to suppress the first non-linear increment signal; and
　an output end (240), configured to output the at least two signals amplified by the power tube (220),
　wherein the input end (210) is connected to the output end (240) through the power tube (220), and the power tube (220) is connected to the first suppression circuit (230);

an input matching circuit (260), configured to match a first impedance of the input end (210) into a second impedance input by the power tube (220);

an output matching circuit (270), configured to match a third impedance output by the power tube (220) into a fourth impedance of the output end (240), wherein

the input end (210) is connected to the power tube (220) by using the input matching circuit (260), and the power tube (220) is connected to the output end (240) by using the output matching circuit (270);

an input bias circuit (280), configured to supply power to the power tube (220) by using the input matching circuit (260); and

an output bias circuit (290), configured to supply power to the power tube (220) by using the output matching circuit (270);

wherein the input end (210) is further configured to:

input, to the power tube (220), a second non-linear increment signal generated by a previous-stage power amplifier (200); and

the power amplifier (200) further comprises:

a second suppression circuit (250), configured to suppress the second non-linear increment signal, wherein

the input end (210) is connected to the second suppression circuit (250),

wherein the second suppression circuit (250) comprises a second capacitor (252) and a second inductor (251), and the second capacitor (252) and the second inductor (251) are configured to perform short-circuit processing on an impedance at a frequency of the second non-linear increment signal; wherein a resonance frequency of the second inductor (251) and the second capacitor (252) is determined by frequencies of input signals of the previous-stage power amplifier;

wherein the resonance frequency of the second inductor (251) and the second capacitor (252) is determined by a difference between the frequencies of the input signals of the previous-stage power amplifier;

wherein the first suppression circuit (230) comprises a first capacitor (232) and a first inductor (231), and the first inductor (231) and the first capacitor (232) are configured to perform short-circuit processing on an impedance at a frequency of the first non-linear increment signal;

wherein a resonance frequency of the first inductor (231) and the first capacitor (232) is determined by the frequencies of the at least two signals;

wherein the resonance frequency of the first inductor (231) and the first capacitor (232) is determined by a difference between the frequencies of the at least two signals;

wherein an inductance value of the first inductor (231) and a capacitance value of the first capacitor (232) are adaptive and adjustable, so that a resonance frequency becomes adaptive and adjustable with the frequency of the input signal.

**Patentansprüche**

1. Leistungsverstärker (200), umfassend:

ein Eingabeende (210), das konfiguriert ist zum Eingeben von mindestens zwei Signalen mit unterschiedlichen Frequenzen;
eine Leistungsröhre (220), die konfiguriert ist zum:

Verstärken der mindestens zwei Signale, die durch das Eingabeende (210) eingegeben werden, und Generieren eines ersten nicht-linearen Inkrementsignals der mindestens zwei Signale; eine erste Unterdrückungsschaltung (230), die konfiguriert ist zum Unterdrücken des ersten nicht-linearen Inkrementsignals; und
ein Ausgabeende (240), das konfiguriert ist zum Ausgeben der mindestens zwei Signale, die von der Leistungsröhre (220) verstärkt wurden,
wobei das Eingabeende (210) mit dem Ausgabeende (240) durch die Leistungsröhre (220) verbunden ist, und die Leistungsröhre (220) mit der ersten Unterdrückungsschaltung (230) verbunden ist;
eine Eingabeanpassungsschaltung (260), die konfiguriert ist zum Anpassen einer ersten Impedanz des Eingabeendes (210) an eine zweite Impedanzeingabe durch die Leistungsröhre (220);
eine Ausgabeanpassungsschaltung (270), die konfiguriert ist zum Anpassen einer dritten Impedanzausgabe durch die Leistungsröhre (220) an eine vierte Impedanz des Ausgabeendes (240), wobei das Eingabeende (210) unter Verwendung der Eingabeanpassungsschaltung (260) mit der Leistungsröhre (220) verbunden ist, und die Leistungsröhre (220) unter Verwendung der Ausgabeanpassungsschaltung (270) mit dem Ausgabeende (240) verbunden ist;

eine Eingabevorspannschaltung (280), die konfiguriert ist zum Zuführen von Leistung zu der Leistungsröhre (220) unter Verwendung der Eingabeanpassungsschaltung (260); und

eine Ausgabevorspannschaltung (290), die konfiguriert ist zum Zuführen von Leistung zu der Leistungsröhre (220) unter Verwendung der Ausgabeanpassungsschaltung (270);

wobei das Eingabeende (210) des Weiteren konfiguriert ist zum:

Eingeben eines zweiten nicht-linearen Inkrementsignals, das durch einen Leistungsverstärker (200) der vorhergehenden Stufe generiert wurde, in die Leistungsröhre (220); und

wobei der Leistungsverstärker (200) des Weiteren umfasst:

eine zweite Unterdrückungsschaltung (250), die konfiguriert ist zum Unterdrücken des zweiten nicht-linearen Inkrementsignals, wobei das Eingabeende (210) mit der zweiten Unterdrückungsschaltung (250) verbunden ist;

wobei die zweite Unterdrückungsschaltung (250) einen zweiten Kondensator (252) und einen zweiten Induktor (251) umfasst, und der zweite Kondensator (252) und der zweite Induktor (251) konfiguriert sind, um an einer Impedanz bei einer Frequenz des zweiten nicht-linearen Inkrementsignals Kurzschlussverarbeitung durchzuführen; wobei eine Resonanzfrequenz des zweiten Induktors (251) und des zweiten Kondensators (252) durch Frequenzen von Eingabesignalen des Leistungsverstärkers der vorhergehenden Stufe bestimmt wird;

wobei die Resonanzfrequenz des zweiten Induktors (251) und des zweiten Kondensators (252) durch eine Differenz zwischen den Frequenzen der Eingabesignale des Leistungsverstärkers der vorhergehenden Stufe bestimmt wird;

wobei die erste Unterdrückungsschaltung (230) einen ersten Kondensator (232) und einen ersten Induktor (231) umfasst, und der erste Induktor (231) und der erste Kondensator (232) so konfiguriert sind, dass sie Kurzschlussverarbeitung an einer Impedanz bei einer Frequenz des ersten nicht-linearen Inkrementsignals durchführen;

wobei eine Resonanzfrequenz des ersten Induktors (231) und des ersten Kondensators (232) durch die Frequenzen der mindestens zwei Signale bestimmt wird;

wobei die Resonanzfrequenz des ersten Induktors (231) und des ersten Kondensators (232) durch eine Differenz zwischen den Frequenzen der mindestens zwei Signale bestimmt wird;

wobei ein Induktivitätswert des ersten Induktors (231) und ein Kapazitätswert des ersten Kondensators (232) adaptiv und einstellbar sind, so dass eine Resonanzfrequenz adaptiv und einstellbar mit der Frequenz des Eingabesignals wird.

**Revendications**

1. Amplificateur de puissance (200), comprenant :

une extrémité d'entrée (210), configurée pour entrer au moins deux signaux de fréquences différentes ;
un tube de puissance (220), configuré pour :

amplifier les au moins deux signaux entrés par l'extrémité d'entrée (210), et
générer un premier signal d'incrémentation non linéaire parmi les au moins deux signaux ;
un premier circuit de suppression (230), configuré pour supprimer le premier signal d'incrémentation non linéaire ; et
une extrémité de sortie (240), configurée pour sortir les au moins deux signaux amplifiés par le tube de puissance (220),
dans lequel l'extrémité d'entrée (210) est connectée à l'extrémité de sortie (240) par l'intermédiaire du tube de puissance (220), et le tube de puissance (220) est connecté au premier circuit de suppression (230) ;
un circuit d'adaptation d'entrée (260), configuré pour adapter une première impédance de l'extrémité d'entrée (210) à une deuxième impédance entrée par le tube de puissance (220) ;
un circuit d'adaptation de sortie (270), configuré pour adapter une troisième impédance sortie par le tube de puissance (220) à une quatrième impédance de l'extrémité de sortie (240), dans lequel

l'extrémité d'entrée (210) est connectée au tube de puissance (220) à l'aide du circuit d'adaptation d'entrée (260), et le tube de puissance (220) est connecté à l'extrémité de sortie (240) à l'aide du circuit d'adaptation de sortie (270) ;

un circuit de polarisation d'entrée (280), configuré pour alimenter le tube de puissance (220) en utilisant le circuit d'adaptation d'entrée (260) ; et

un circuit de polarisation de sortie (290), configuré pour alimenter le tube de puissance (220) en utilisant le circuit d'adaptation de sortie (270) ;

dans lequel l'extrémité d'entrée (210) est en outre configurée pour :

entrer, dans le tube de puissance (220), un second signal d'incrémentation non linéaire généré par un amplificateur de puissance d'étage précédent (200) ; et

l'amplificateur de puissance (200) comprend en outre :

un second circuit de suppression (250), configuré pour supprimer le second signal d'incrémentation non linéaire, dans lequel

l'extrémité d'entrée (210) est connectée au second circuit de suppression (250) ;

dans lequel le second circuit de suppression (250) comprend un second condensateur (252) et une seconde inductance (251), et le second condensateur (252) et la seconde inductance (251) sont configurés pour effectuer un traitement de court-circuit sur une impédance à une fréquence du second signal d'incrémentation non linéaire ; dans lequel une fréquence de résonance de la seconde inductance (251) et du second condensateur (252) est déterminée par des fréquences de signaux d'entrée de l'amplificateur de puissance d'étage précédent ;

dans lequel la fréquence de résonance de la seconde inductance (251) et du second condensateur (252) est déterminée par une différence entre les fréquences des signaux d'entrée de l'amplificateur de puissance d'étage précédent ;

dans lequel le premier circuit de suppression (230) comprend un premier condensateur (232) et une première inductance (231), et la première inductance (231) et le premier condensateur (232) sont configurés pour effectuer un traitement de court-circuit sur une impédance à une fréquence du premier signal d'incrémentation non linéaire ;

dans lequel une fréquence de résonance de la première inductance (231) et du premier condensateur (232) est déterminée par les fréquences des au moins deux signaux ;

dans lequel la fréquence de résonance de la première inductance (231) et du premier condensateur (232) est déterminée par la différence entre les fréquences des deux au moins signaux ;

dans lequel une valeur d'inductance de la première inductance (231) et une valeur de capacité du premier condensateur (232) sont adaptables et réglables, de sorte qu'une fréquence de résonance devient adaptable et réglable en fonction de la fréquence du signal d'entrée.

100

Input signal → First-stage power amplifier → Second-stage power amplifier → ... → $(n-1)^{th}$-stage power amplifier → $n^{th}$-stage power amplifier → Output signal

FIG. 1

Power amplifier 200

Input end 210 → Power tube 220 → Output end 240

First suppression circuit 230

FIG. 2

Power amplifier 200

Input end 210 → Power tube 220 → Output end 240

First suppression circuit 230

First inductor 231

First capacitor 232

FIG. 3

15

FIG. 4

FIG. 5

FIG. 6

FIG. 7

Power amplifier 200

| Input end 210 | Input matching circuit 260 | Power tube 220 | Output matching circuit 270 | Output end 240 |

Second suppression circuit 250

First suppression circuit 230

FIG. 8

Power amplifier 200

Input bias circuit 280

Output bias circuit 290

| Input end 210 | Input matching circuit 260 | Power tube 220 | Output matching circuit 270 | Output end 240 |

Second suppression circuit 250

First suppression circuit 230

FIG. 9

Power amplifier 300

| Input end 310 | | Power tube 330 | Output end 340 |

Second suppression circuit 320

FIG. 10

Power amplifier 300

| Input end 310 | | Power tube 330 | Output end 340 |

Second suppression circuit 320

Second inductor 321

Second capacitor 322

FIG. 11

Power amplifier 400

Input end 401 — Power splitter 402

Input bias circuit 404 — Input matching circuit 403 — Second suppression circuit 405

Power tube 406

Output bias circuit 408 — Output matching circuit 407 — First suppression circuit 409

Input bias circuit 411 — Input matching circuit 410 — Second suppression circuit 412

Power tube 413

Output bias circuit 415 — Output matching circuit 414 — First suppression circuit 416

Combining unit 417 — Output end 418

FIG. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201710602258
- US 2002067212 A1
- US 20020606 B